# EUROPEAN PATENT APPLICATION

(11) **EP 4 723 853 A1**
(43) Date of publication of application: **08.04.2026**
(21) Application number: 24896786.1
(22) Date of filing: 02.12.2024
(51) Int. Cl.: H10K 59/131

(54) **DISPLAY MODULE, DISPLAY SCREEN AND DISPLAY DEVICE**

(30) Priority: 30.11.2023 CN 202311649032
(71) Applicant: GUANGDONG OPPO MOBILE TELECOMMUNICATIONS CORP., LTD., Dongguan, Guangdong 523860 (CN)
(72) Inventor: LIU, Changyu, Dongguan, Guangdong 523860 (CN); KONG, Xiangyong, Dongguan, Guangdong 523860 (CN)
(74) Representative: Novagraaf Technologies
(86) International application number: PCT/CN2024/136134
(87) International publication number: WO 2025/113707

(57) **Abstract**

The present application relates to a display module, a display screen and a display device. The display module has a display area (10), a fan-out area (20) and a bonding area (30) which are sequentially arranged in a first direction, the display area (10) comprises a first display area (101) and a second display area (102) which are sequentially arranged in a second direction, and the fan-out area is adjacent to the second display area (102), wherein the first direction and the second direction intersect with each other, and the first direction and the second direction are oriented perpendicularly to the thickness direction of the display module. The display module comprises: a plurality of data lines (110) and a plurality of first connecting traces (120) that are arranged in the display area (10), and a plurality of fan-out traces that are arranged in the fan-out area (20), wherein the fan-out traces are used for transmitting to the data lines (110) data signals outputted by the bonding area (30). The plurality of data lines (110) are arranged in the display area (10), and the plurality of data lines (110) extend in the first direction and are arranged in the second direction; the plurality of first connecting traces (120) are arranged in the display area (10), first ends of the plurality of first connecting traces (120) are correspondingly connected to the data lines (110) located in the first display area (101), and second ends of the plurality of first connecting traces (120) are located in the second display area (102); and for two adjacent data lines (110) located in the first display area (101), the distance between a first connecting trace (120) correspondingly connected to the data line (110) away from the second display area (102) and a virtual intersection point is greater than the distance between a first connecting trace (120) correspondingly connected to the data line (110) close to the second display area (102) and the virtual intersection point, wherein the virtual intersection point is an intersection point of a first extended line and a second extended line, the first extended line is an extended line of the side edge of the first display area (101) away from the second display area (102), and the second extended line is an extended line of the side edge of the second display area (102) close to the fan-out area (20). The plurality of fan-out traces are arranged in the fan-out area (20), one end of some of the fan-out traces is correspondingly connected to the data lines (110) located in the second display area (102), and the other fan-out traces are correspondingly connected to the second ends of the plurality of first connecting traces (120), the other ends of the plurality of fan-out traces are correspondingly connected to a plurality of pins arranged in the second direction in the bonding area (30), each pin is used for transmitting a data signal to a correspondingly connected data line (110), and the arrangement sequence of pins among the plurality of pins is the same as the arrangement sequence of data lines (110) correspondingly connected thereto among the plurality of data lines (110).

## Description

### CROSS REFERENCE TO RELATED APPLICATIONS

This application claims priority to China Patent Applicant No. 202311649032X, filed on November 30, 2023 in the China National Intellectual Property Administration and entitled "DISPLAY MODULE, DISPLAY SCREEN, AND DISPLAY DEVICE", the entire contents of which are incorporated herein by reference.

### TECHNICAL FIELD

Embodiments of the present disclosure relate to the field of display technologies, in particular, to a display module, a display screen, and a display device.

### BACKGROUND

The statements herein are provided only as background information relevant to the present disclosure and may not necessarily constitute exemplary techniques.

With the continuous development of display technology, requirements for external appearances of display devices become increasingly stringent. As full-screen displays have already become widespread in the market, it is important to narrow bezels of the display screens and improve screen-to-body ratios. However, bezel widths of the current display devices may no longer meet users' requirements. Thus, there is an urgent need to provide a display device with a narrower lower bezel.

### SUMMARY

Some embodiments of the present disclosure provide a display module, a display screen, and a display device, which may achieve a narrow-bezel requirement without affecting the functionality of a bonding region.

In a first aspect, some embodiments of the present disclosure provide a display module. The display module defines a display region, a fan-out region, and a bonding region sequentially along a first direction. The display region includes a first display region and a second display region that are sequentially disposed along a second direction. The fan-out region is adjacent to the second display region. The first direction and the second direction intersects with each other. The display module includes a plurality of data lines, a plurality of first connection traces, and a plurality of fan-out traces. The plurality of data lines are disposed in the display region. The plurality of data lines extend along the first direction and are arranged along the second direction. The plurality of first connection traces are disposed in the display region. A first end of each of the plurality of first connection traces is connected to a corresponding one of the plurality of data lines located in the first display region. A second end of each of the plurality of first connection traces is located in the second display region. Among adjacent two of the plurality of data lines located in the first display region, a distance between a virtual intersection point and one of the first connection traces correspondingly connected to one of the adjacent two of the plurality of data lines that is farther from the second display region is greater than a distance between the virtual intersection point and another one of the first connection traces correspondingly connected to the other one of the adjacent two of the plurality of data lines that is closer to the second display region. The virtual intersection point is an intersection point of a first extension line and a second extension line. The first extension line is an extension line of an edge of the first display region that is away from the second display region. The second extension line is an extension line of an edge of the second display region that is adjacent to the fan-out region. The plurality of fan-out traces are disposed in the fan-out region. For a part of the plurality of fan-out traces, an end of each of the plurality of fan-out traces is connected to a corresponding one of the plurality of data lines located in the second display region. For another part of the plurality of fan-out traces, an end of each of the plurality of fan-out traces is connected to the second end of a corresponding one of the plurality of first connection traces. Another end of each of the plurality of fan-out traces is connected to a corresponding one of a plurality of pins disposed along the second direction in the bonding region. Each of the plurality of pins is configured to transmit a data signal to a corresponding one of data lines connected thereto. An arrangement sequence of each of the plurality of pins is the same as an arrangement sequence of the corresponding one of the plurality of data lines connected thereto.

In a second aspect, some embodiments of the present disclosure provide a display module. The display module defines a display region, a fan-out region, and a bonding region sequentially along a first direction. The display region includes a first display region and a second display region that are sequentially disposed along a second direction. The fan-out region is adjacent to the second display region. The first direction and the second direction intersect with each other. The display module includes a plurality of data lines disposed in the display region and a plurality of first connection traces disposed in the display region. The plurality of data lines extend along the first direction and are arranged along the second direction. A first end of each of the plurality of first connection traces is connected to a corresponding one of the plurality of data lines located in the first display region. A second end of each of the plurality of first connection traces is connected to a corresponding one of the plurality of fan-out traces and is located in the second display region. Among adjacent two of the plurality of first connection traces, one of the adjacent two of the plurality of first connection traces of which the first end is closer to the second display region is defined as a first sub connection trace, the other one of the adjacent two of the plurality of first connection traces of which the first end is farther from the second display region is defined as a second sub connection trace. The second end of the first sub connection trace is closer to the first display region than the second end of the second sub connection trace. For a part of the plurality of fan-out traces, an end of each of the plurality of fan-out traces is connected to a corresponding one of the plurality of data lines located in the second display region. For another part of the plurality of fan-out traces, an end of each of the plurality of fan-out traces is connected to the second end of a corresponding one of the plurality of first connection traces. Another end of each of the plurality of fan-out traces is connected to a corresponding one of a plurality of pins disposed along the second direction in the bonding region. Each of the plurality of pins is configured to transmit a data signal to a corresponding one of data lines connected thereto. An arrangement sequence of each of the plurality of pins is the same as an arrangement sequence of the corresponding one of the plurality of data lines connected thereto.

In a third aspect, some embodiments of the present disclosure provide a display module. The display module defines a display region, a fan-out region, and a bonding region sequentially along a first direction. The display region includes a first display region and a second display region that are sequentially disposed along a second direction. The fan-out region is adjacent to the second display region. The first direction and the second direction intersect with each other. The display module includes a plurality of data lines disposed in the display region, a plurality of first connection traces disposed in the display region, and a plurality of fan-out traces disposed in the fan-out region. The plurality of data lines extend along the first direction and are arranged along the second direction. A first end of each of the plurality of first connection traces is connected to a corresponding one of the plurality of data lines located in the first display region. A second end of each of the plurality of first connection traces is located in the second display region. Among adjacent two of the plurality of data lines located in the first display region, a length of one of the plurality of first connection traces that is connected to one of the adjacent two of the plurality of data lines farther from the second display region is greater than a length of another one of the plurality of first connection traces that is connected to the other one of the adjacent two of the plurality of data lines closer to the second display region. For a part of the plurality of fan-out traces, an end of each of the plurality of fan-out traces is connected to a corresponding one of the plurality of data lines located in the second display region. For another part of the plurality of fan-out traces, an end of each of the plurality of fan-out traces is connected to another end of a corresponding one of the plurality of first connection traces. Another end of each of the plurality of fan-out traces is connected to a corresponding one of a plurality of pins disposed along the second direction in the bonding region. Each of the plurality of pins is configured to transmit a data signal to a corresponding one of data lines connected thereto. An arrangement sequence of each of the plurality of pins is the same as an arrangement sequence of the corresponding one of the plurality of data lines connected thereto.

In a fourth aspect, some embodiments of the present disclosure provide a display screen. The display screen includes a cover plate and the display module mentioned above.

In a fifth aspect, some embodiments of the present disclosure provide a display device. The display device includes the above mentioned display screen. Details of one or more embodiments of the present disclosure are set forth in the accompanying drawings and the description below. Other features, objectives, and technical effects of the present disclosure will be apparent from the description, the drawings, and the claims.

### BRIEF DESCRIPTION OF THE DRAWINGS

In order to describe the technical solutions in some embodiments of the present disclosure or in the related art more clearly, the accompanying drawings used in the embodiments or in the description of the related art are briefly introduced below. It is apparent that the drawings described below may merely illustrate some embodiments of the present disclosure, and for those skilled in the art, other drawings may be obtained based on these drawings without any inventive effort.
FIG. 1 is a first schematic structural view of a display module according to some embodiments.
FIG. 2 is a second schematic structural view of the display module according to some embodiments.
FIG. 3 is a first partial enlarged view of a display region according to some embodiments.
FIG. 4 is a schematic partial structural view of a display module formed by combining pixel circuits and light-emitting devices according to some embodiments.
FIG. 5 is a schematic circuit view of a pixel circuit according to some embodiments.
FIG. 6 is a first cross-sectional schematic view of the display module according to some embodiments.
FIG. 7 is a partial enlarged view of a first connection trace/wiring according to some embodiments.
FIG. 8 is a third schematic structural view of the display module according to some embodiments.
FIG. 9 is a fourth schematic structural view of the display module according to some embodiments.
FIG. 10 is a fifth schematic structural view of the display module according to some embodiments.
FIG. 11 is a second cross-sectional schematic view of the display module according to some embodiments.
FIG. 12 is a sixth schematic structural view of the display module according to some embodiments.
FIG. 13 is a third cross-sectional schematic view of the display module according to some embodiments.
FIG. 14 is a seventh schematic structural view of the display module according to some embodiments.
FIG. 15 is a second partial enlarged view of the display region according to some embodiments.

### DETAILED DESCRIPTION

To make the objectives, technical solutions, and technical effects of the present disclosure clearer, the present disclosure may be further described below in detail with reference to the accompanying drawings and embodiments. It should be understood that the embodiments described herein may serve only to explain the present disclosure and may not be intended to limit the same.

It may be understood that the terms "first", "second", and the like used in the present disclosure may be employed to describe various components but may not be limited to these terms. These terms may merely be used to distinguish one element from another. For example, without departing from the scope of the present disclosure, a pixel circuit may be referred to as a second pixel circuit, and similarly, the second pixel circuit may be referred to as a pixel circuit. Both the pixel circuit and the second pixel circuit may be pixel circuits, but they may not be the same pixel circuit.

Furthermore, the terms "first" and "second" may be used for descriptive purposes only and may not be construed as indicating or implying relative importance or suggesting the number of technical features indicated. Therefore, a feature defined as "first" or "second" may explicitly or implicitly include at least one such feature. In the description of the present disclosure, the term "plurality" may refer to at least two, such as two, three, and so on, unless explicitly specified otherwise. In the description of the present disclosure, the term "multiple" may refer to at least one, such as one, two, and so on, unless explicitly specified otherwise.

The display module described in some embodiments of the present disclosure may be applied to or configured in a narrow-bezel display device. The display device may be a smartphone, a tablet, a gaming device, an augmented reality (AR) device, a laptop, a desktop computing device, a wearable device, or the like. For ease of understanding, the display device may be exemplified below as a smartphone.

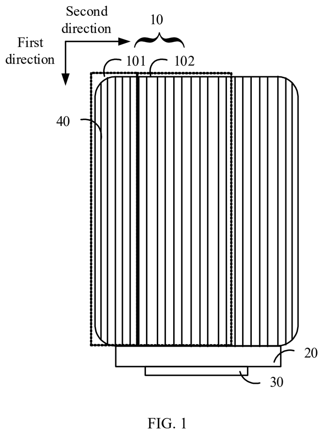

FIG. 1 is a first schematic structural view of a display module according to some embodiments. As shown in FIG. 1, the display module may include, in sequence along a first direction, a display region 10, a fan-out region 20, and a bonding region 30. The display region may include, in sequence along a second direction, a first display region 101 and a second display region 102. The fan-out region may be adjacent to the second display region 102. The first direction and the second direction may intersect with each other. Each of the first direction and the second direction may be defined substantially perpendicular to a thickness direction of the display module. The display region may be an active area (AA) region capable of displaying images. The first display region 101 may be understood as a display region located at an edge portion of the AA region. The second display region 102 may be understood as a display region located at a central portion of the AA region. The fan-out region may be a fan-out region configured to arrange fan-out traces/wirings. The bonding region 30 may be configured to arrange a display driving chip.

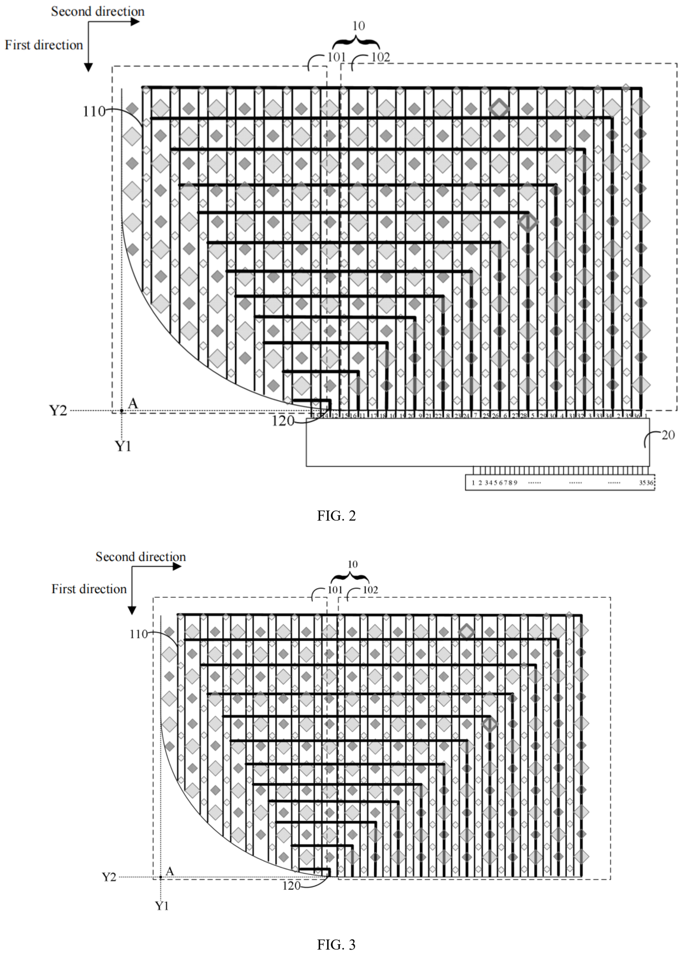

As shown in FIG. 2, the display module may include both a plurality of data lines 110 and a plurality of first connection traces/wirings 120 disposed in the display region. The display module may further include a plurality of fan-out traces (not shown in the figure) disposed in the fan-out region. The fan-out traces may be configured to transmit a data signal output from the bonding region 30 to the data lines 110.

The plurality of data lines 110 may be disposed in the display region 10. The plurality of data lines 110 may extend along the first direction and be disposed along the second direction. The plurality of first connection traces 120 (distinguished by different line thicknesses in the figures, where the data lines 110 are thinner and the first connection traces 120 are thicker) may be disposed in the display region 10. A first end of each of the plurality of first connection traces 120 may be connected to a corresponding one of the data lines 110 located in the first display region 101. A second end of each of the plurality of first connection traces 120 may be located in the second display region 102. For two adjacent data lines 110 located in the first display region 101, a distance between a virtual intersection point and a first connection trace 120 connected to the data line 110 that is farther from the second display region 102 may be greater than a distance between the virtual intersection point and another first connection trace 120 connected to the other data line 110 that is closer to the second display region 102. The virtual intersection point may be an intersection point (e.g., point A in the figures) between a first extension line (e.g., line Y1 in the figures) and a second extension line (e.g., line Y2 in the figures). The first extension line may be an extension line of an edge of the first display region 101 that is away from the second display region 102. The second extension line may be an extension line of an edge of the second display region 102 that is adjacent to the fan-out region 20.

The plurality of fan-out traces may be disposed in the fan-out region 20. For a part of the fan-out traces, an end of each fan-out trace may be connected to a corresponding one of the data lines 110 located in the second display region 102. For another part of the fan-out traces, an end of each fan-out trace may be connected to the second end of a corresponding one of the plurality of first connection traces 120. Another end of each of the plurality of fan-out traces may be connected to a corresponding one of a plurality of pins disposed along the second direction in the bonding region 30. Each pin may be configured to transmit a data signal to the corresponding data line 110 connected thereto. An arrangement sequence of each of the plurality of pins may be identical to an arrangement sequence of the corresponding one of the plurality of data lines 110 connected thereto.

The plurality of data lines 110 may include multiple data lines 110 disposed in the first display region 101 and multiple data lines 110 disposed in the second display region 102. The multiple data lines 110 disposed in the first display region 101 may be connected to the multiple fan-out traces in the fan-out region 20 through the plurality of first connection traces 120. The multiple data lines 110 disposed in the second display region 102 may be directly connected to the multiple fan-out traces in the fan-out region 20.

In a first aspect, the second ends of the plurality of first connection traces 120 that are connected to the multiple fan-out traces may be disposed in the second display region 102. Accordingly, by means of the plurality of first connection traces 120, the multiple fan-out traces correspondingly connected to the multiple data lines 110 in the first display region 101 may be transferred to the second display region 102, that is, away from an edge region of the display module. In this way, a fan-out wiring or routing in the fan-out region 20 may be gathered or concentrated in a central region beneath the second display region 102, thereby reducing a wiring space of the fan-out region 20 and further reducing a width of a lower bezel of the display module. It may be understood that a ratio of the multiple data lines 110 disposed in the first display region 101 to all of the data lines 110 in the display module may be set based on an outer contour shape of the display module or a width requirement of the lower bezel, which is not limited herein. Furthermore, it may be understood that a size of the second display region 102 along the second direction is generally greater than a size of the first display region 101 along the second direction. Thus, the second display region 102 may have more accommodation space for accommodating the plurality of first connection traces 120.

In a second aspect, a lower bezel edge region of the first display region 101 that is close to the virtual intersection point may be close to the fan-out region 20 in the first direction and may be away from the second display region 102 in the second direction. The lower bezel edge region may be a rounded region of an edge display region, where the data lines 110 farther from the second display region 102 may be shorter than the data lines 110 closer to the second display region 102. Accordingly, through arranging two adjacent data lines 110 in the first display region 101 in such a way that the distance between the virtual intersection point and the first connection trace 120 connected to the data line 110 that is farther from the second display region 102 is greater than the distance between the virtual intersection point and the another first connection trace 120 connected to the other data line 110 that is closer to the second display region 102, the connection traces may be disposed in positions other than the lower bezel edge region, thereby reducing occupation of the lower bezel edge region and further narrowing a size of the lower bezel.

In a third aspect, in possible related art, a first connection trace 120 correspondingly connected to a data line 110 in the first display region 101 that is farther from the second display region 102 is typically disposed closer to the virtual intersection point. In addition, a first connection trace 120 correspondingly connected to a data line 110 in the first display region 101 that is closer to the second display region 102 is disposed farther away from the virtual intersection point. As a result, sizes of the connection traces in the first direction may become relatively large, leading to an overall larger occupied area of the connection traces, which may increase a coupling strength between the connection traces and the data lines 110 during signal transmission. In some embodiments of the present disclosure, two adjacent data lines 110 in the first display region 101 may be disposed in such a way that the distance between the first connection trace 120 connected to the data line 110 farther from the second display region 102 and the virtual intersection point is greater than the distance between another first connection trace 120 connected to the other data line 110 closer to the second display region 102 and the virtual intersection point. As a result, an outermost first connection trace 120 may have a larger size in the first direction than other inner first connection traces 120 located near the lower bezel edge region. In this way, the inner connection traces may have smaller sizes, resulting in a smaller overall wiring occupation area. The above may further reduce the coupling between the first connection traces 120 and the data lines 110 during signal transmission, thereby reducing parasitic capacitance generated between the first connection traces 120 and the data lines 110, and effectively decreasing the delay and attenuation of data signals during transmission.

An arrangement sequence of each pin of the data signal among the plurality of pins in the bonding region 30 may be identical to an arrangement sequence of the corresponding data line 110 connected thereto among the plurality of data lines 110. Each pin may be configured to transmit the data signal to the corresponding data line connected thereto. In possible related art, in a case where the arrangement sequence of the multiple fan-out traces in the fan-out region 20 is not adjusted or transferred, since the second ends of the first connection traces 120 are located in the second display region 102, the arrangement sequence among the second ends of the first connection traces 120 and the data lines 110 in the second display region 102 may be disrupted, resulting in an inconsistency with an original arrangement sequence of the plurality of data lines 110 along the second direction. In some embodiments of the present disclosure, through the fan-out traces in the fan-out region 20, the data lines 110 in the second display region 102 and the first connection traces 120, whose arrangement sequence has been disrupted, may be transferred according to the original arrangement sequence of the data lines 110 along the second direction, to be connected to the plurality of pins of the bonding region 30. In this way, the plurality of pins in the bonding region 30 may still maintain the same arrangement sequence as the data lines 110, without having to alter the arrangement sequence of the pins. Thus, a manufacturing cost of the display screen may be reduced and a narrow bezel requirement may be achieved without affecting the functionality of the bonding region 30.

The display module provided in some embodiments of the present disclosure may include both the plurality of data lines 110 and the plurality of first connection traces 120 disposed in the display region and the plurality of fan-out traces disposed in the fan-out region 20. The fan-out traces may be configured to transmit the data signals output from the bonding region 30 to the data lines 110. Through the plurality of first connection traces 120, the multiple fan-out traces correspondingly connected to the plurality of data lines 110 in the first display region 101 may be transferred to the second display region 102, that is, away from the edge region of the display module. As a result, the wiring of the fan-out region 20 may be gathered in the central region beneath the second display region 102, reducing the wiring space of the fan-out region 20 and further reducing the width of the lower bezel of the display module. The first connection trace 120 correspondingly connected to the data line 110 in the first display region 101 that is farther from the second display region 102 may be disposed farther from the virtual intersection point. The first connection trace 120 correspondingly connected to the data line 110 in the first display region 101 that is closer to the second display region 102 may be disposed closer to the virtual intersection point. As a result, the connection traces may be disposed in positions other than the lower bezel edge region, thereby reducing occupation of the lower bezel edge region and further narrowing the size of the lower bezel. In addition, an overall wiring occupation area may be further reduced, thereby decreasing coupling between the first connection traces 120 and the data lines 110 during signal transmission, reducing parasitic capacitance generated between the first connection traces 120 and the data lines 110, and effectively decreasing delay and attenuation of data signals during transmission. Furthermore, through the fan-out traces in the fan-out region 20, the data lines 110 in the second display region 102 and the first connection traces 120, whose arrangement sequence has been disrupted, may be transferred according to the original arrangement sequence of the data lines 110 along the second direction, to be connected to the plurality of pins of the bonding region 30. In this way, the plurality of pins in the bonding region 30 may still maintain the same arrangement sequence as the data lines 110, without having to alter the arrangement sequence of the pins. Thus, the manufacturing cost of the display screen may be reduced and a narrow bezel requirement may be achieved without affecting the functionality of the bonding region 30.

In some embodiments, as shown in FIG. 3, for two adjacent first connection traces, an extension size of the first connection trace that is farther from the virtual intersection point in the first direction may be greater than an extension size of the other first connection trace that is closer to the virtual intersection point in the first direction. For two adjacent first connection traces, an extension size of the first connection trace that is farther from the virtual intersection point in the second direction may be greater than an extension size of the other first connection trace that is closer to the virtual intersection point in the second direction.

Accordingly, in one aspect, the first connection trace farther from the virtual intersection point may form an outer trace relative to the first connection trace closer to the virtual intersection point. The first connection trace closer to the virtual intersection point may form an inner trace relative to the first connection trace farther from the virtual intersection point. Such arrangement may allow the connection traces to be disposed in the region other than the lower bezel edge region near the virtual intersection point, thereby reducing occupation of the lower bezel edge region and further narrowing the size of the lower bezel. In another aspect, the overall wiring occupation area may be reduced, and coupling between the first connection traces 120 and the data lines 110 during signal transmission may be further decreased, thereby reducing parasitic capacitance generated between the first connection traces 120 and the data lines 110 and effectively minimizing delay and attenuation of data signals during transmission. In addition, through the foregoing arrangement, no intersection may exist between different first connection traces 120. Thus, no parasitic capacitance or signal crosstalk may occur between the different first connection traces 120, thereby improving the stability and reliability of signals transmitted by the first connection traces 120.

In some embodiments, as shown in FIG. 3, a projection of a trace portion of each first connection trace 120 extending along the first direction in the thickness direction of the display module that may be located within a gap between two adjacent data lines 110. The gap between two adjacent data lines 110 may be understood as an unused location without occupying any additional space. On one hand, the above design may facilitate the arrangement of the first connection traces 120 along the first direction and improve the uniformity of spacing between the first connection trace 120 and the two data lines 110 adjacent thereto along the second direction. On the other hand, the unused location may further facilitate the connection with another trace portion of the first connection traces 120 that extend in another direction.

It may be understood that, in some embodiments, one first connection trace 120 may be disposed within the gap between two adjacent data lines 110. In some other embodiments, multiple first connection traces 120 may be disposed within the gap between two adjacent data lines 110, where arrangements may be adjusted according to a display type, a display area, and etc. of the display module and will not be limited herein.

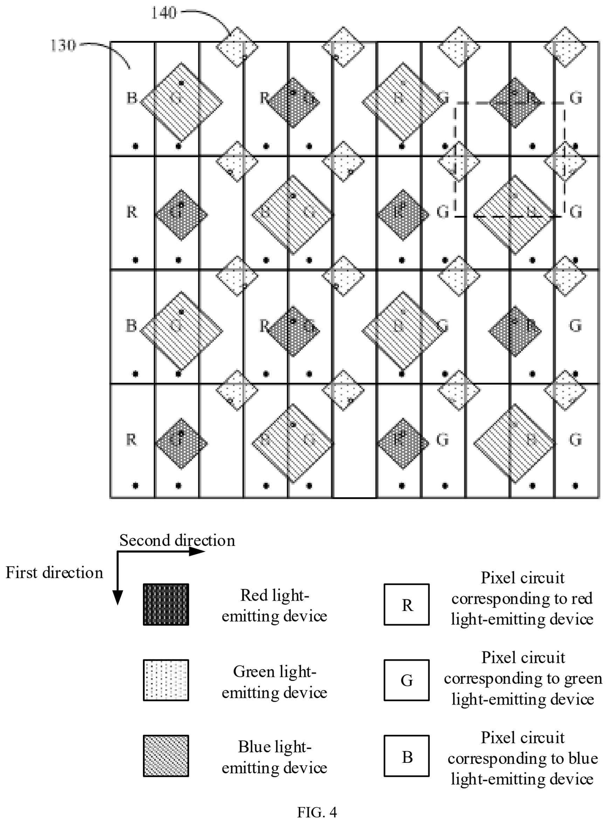

Furthermore, the display module may further include a plurality of pixel circuits 130. The plurality of pixel circuits 130 may be disposed in a plurality of columns. The first direction may be substantially parallel to a column direction of the pixel circuits 130. Each column may include multiple pixel circuits 130. Each pixel circuit 130 may be configured to be connected to one light-emitting device 140 to drive the connected light-emitting device 140 to emit light. Each data line 110 may be configured to transmit a data signal to the corresponding pixel circuits 130 in the column direction. In some embodiments, as shown in FIG. 4 (where the data lines 110 are not shown in the figure), two adjacent data lines 110 may respectively be a R/G data line 110 and a B data line 110. The R/G data line 110 may be configured to transmit a data signal to the pixel circuits 130 corresponding to the R/G column, so that the pixel circuits 130 may be configured to drive the connected R/G light-emitting devices 140 to emit light. The B data line 110 may be configured to transmit a data signal to the pixel circuits 130 corresponding to the B column, so that the pixel circuits 130 may be configured to drive the connected B light-emitting devices 140 to emit light. One R light-emitting device 140, one G light-emitting device 140, and two B light-emitting devices 140 that are adjacent to one another may form one pixel unit (see the four light-emitting devices 140 enclosed by a dashed box shown in the figure).

It may be understood that, in the embodiments shown in FIG. 4, colors of the light-emitting devices 140 corresponding to the respective pixel circuits 130 are merely illustrative and are not intended to limit the scope of the present disclosure. The plurality of pixel circuits 130 in the display module may be disposed in a plurality of columns. The first direction may be parallel to the column direction of the pixel circuits 130. It may be further understood that, in some embodiments of the present disclosure, the number of pixel circuits 130 in each column may be the same or different, which may be determined according to a shape of the actual display module and is not limited herein. For example, in a case where the display module is shaped as an irregular screen, such as a waterdrop screen or a notched screen, etc., the number of the pixel circuits 130 in each column within an irregular-shaped region may be fewer than the number of first pixels in other columns. As another example, in a case where an under-display camera needs to be disposed below the display module during installation, the number of pixel circuits 130 in each column within a region corresponding to the under-display camera may be fewer than the number of pixel circuits 130 in other columns.

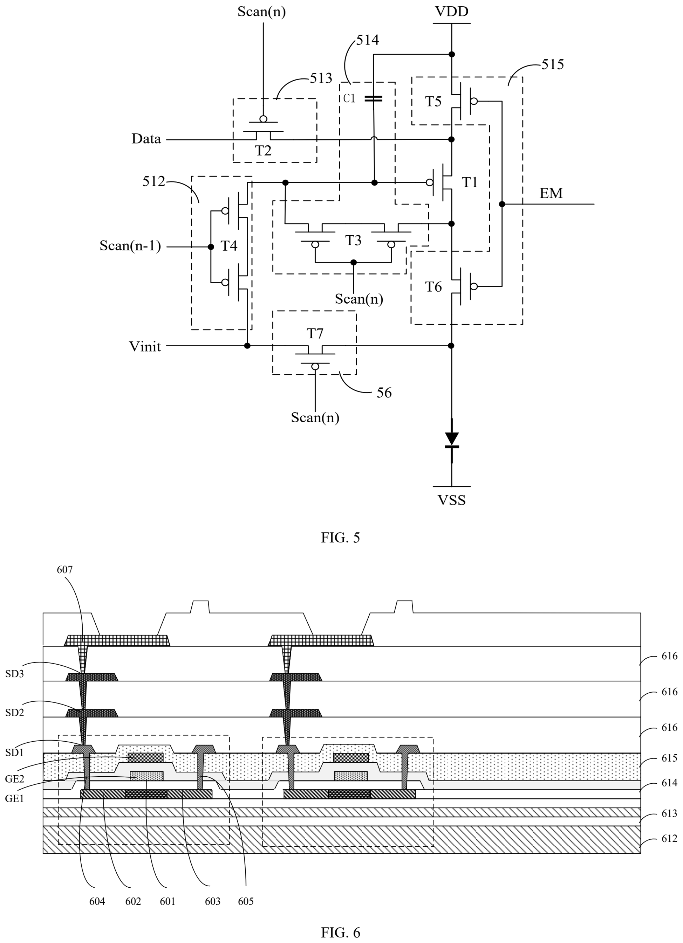

It may be understood that a corresponding circuit type of each pixel circuit 130 may be selected according to actual requirements. For example, the pixel circuit 130 having a 7T1C structure, as shown in FIG. 5, may be selected. Alternatively, a pixel circuit 130 having other circuit types such as 3T1C, 6T1C, or 6T2C structures may be selected. Taking a pixel circuit 130 having the 7T1C structure as an example, the pixel circuit 130 may include, as shown in FIG. 5, a driving transistor T1, an anode reset unit 511, a gate reset unit 512, a data writing unit 513, a threshold compensation unit 514, and a light emission control unit 515. Those skilled in the art, by referring to FIG. 5, may understand respective functions of the above units of the pixel circuit 130 having the 7T1C structure, which thus will not be further described herein.

In some embodiments, a trace portion of the first connection trace 120 may be disposed in the same trace layer as the data lines 110 in the display module. Another trace portion, apart from the former trace portion, of the first connection traces 120 may be disposed in a trace layer different from the trace layer of the data lines 110. The another trace portion may be electrically connected to the trace portion and the corresponding data lines 110, respectively, through vias.

A trace portion of the first connection trace 120 that is located within the gaps between adjacent data lines 110 may be disposed in the same trace layer as the data lines 110. In this way, the space of the trace layer in which the data lines 110 are located may be effectively utilized while a chance of physical contact between the first connection traces 120 and the data lines 110 is reduced. Besides, a manufacturing process may be simplified.

The another trace portion of each first connection trace 120, apart from the trace portion, may be disposed in the trace layer different from the trace layer of the data lines 110 in the display module. The another trace portion may be connected to the trace portion and the data lines 110 through the vias. In this way, a chance of the another trace portion overlapping with the data lines 110 may be reduced, and the coupling between the another trace portion and the data lines 110, thereby reducing parasitic capacitance generated between the another trace portion and the data lines 110 and minimizing delay and attenuation of data signals during transmission.

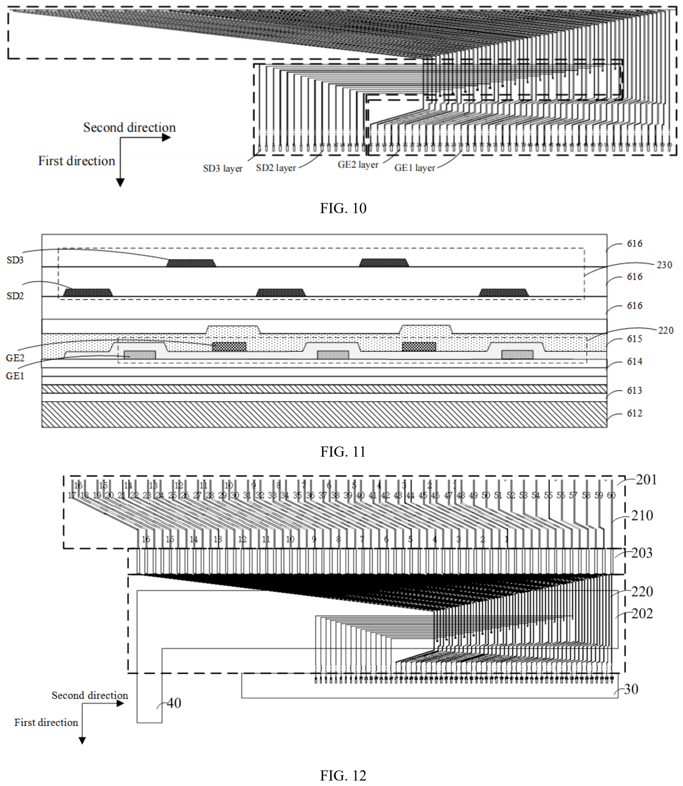

Furthermore, the display module may further include a substrate. As shown in FIG. 6, the substrate may include a polyimide (PI) base 612, a first buffer layer 613, a first gate insulating layer 614, an interlayer insulating layer 615, and a plurality of planarization layers 616 that are sequentially and alternately stacked on each other. In some embodiments shown in FIG. 12, the substrate may include two polyimide (PI) bases 612 and two first buffer layers 613 that are sequentially and alternately disposed on one another. It may be understood that the substrate may further include more PI bases 612 and more first buffer layers 613. The trace portion and the data lines 110 may be a metal layer formed in the planarization layer 613 (i.e., a SD3 layer in the figure). The another trace portion may be a metal layer formed in another planarization layer 613 (i.e., a SD2 layer in the figure). In this way, the trace portion and the data lines 110 may be disposed in a trace layer different from the another trace portion. The data lines 110 and the trace portion may adopt the SD3 layer, which is farther from film layers below, thereby reducing a load of the data lines 110 to a large extent. In addition, the planarization layers 613 that separate the SD2 layer from both the film layers below and the SD3 layer above may be organic layers. The parasitic capacitance between the SD2 layer and SD3 layer may be reduced, thereby reducing the load of the data lines 110 and mitigating effects on the display performance.

The first gate insulating layer 614, the interlayer insulating layer 615, and the planarization layers 616 of the substrate may be configured to form the pixel circuits 130. In some embodiments, each pixel circuit 13060 may include a plurality of transistors. A structure of the transistor may include a first gate 601, a first source 602, a first drain 603, a source contact structure 604, and a corresponding drain contact structure 605. An anode 607 of the light-emitting device 140 may be electrically connected to the first source 602 through the source contact structure 604.

Furthermore, in a case where the trace portion of the first connection trace 120 extending along the first direction is disposed in the same trace layer as the data lines 110, a width of the gap between adjacent data lines 110 may be greater than a width threshold. The width threshold may be understood as a width that ensures the first connection traces 120 to not affect the performance of the display module. On one hand, the first connection traces 120 may be ensured to not affect an optical performance. That is, the first connection traces 120 may be ensured to not result in an abnormal light emission of the display module. On the other hand, the first connection traces 120 may be ensured to not affect an electrical performance. That is, an electrical signal of the first connection traces 120 may be ensured to not interfere with electrical signals of other traces. As such, in some embodiments of the present disclosure, through providing the gap with an appropriate width between adjacent data lines 110, an influence of the first connection traces 120 on display performance may be effectively reduced, thereby improving the display quality of the display module.

In some embodiments, a projection of the trace portion of each first connection trace 120 extending along the first direction in the thickness direction of the display module may partially overlap with the adjacent data lines 110, thereby reducing the gap between the adjacent data lines 110. In this way, a total area occupied by the traces may be decreased and a desired spatial compression may be achieved.

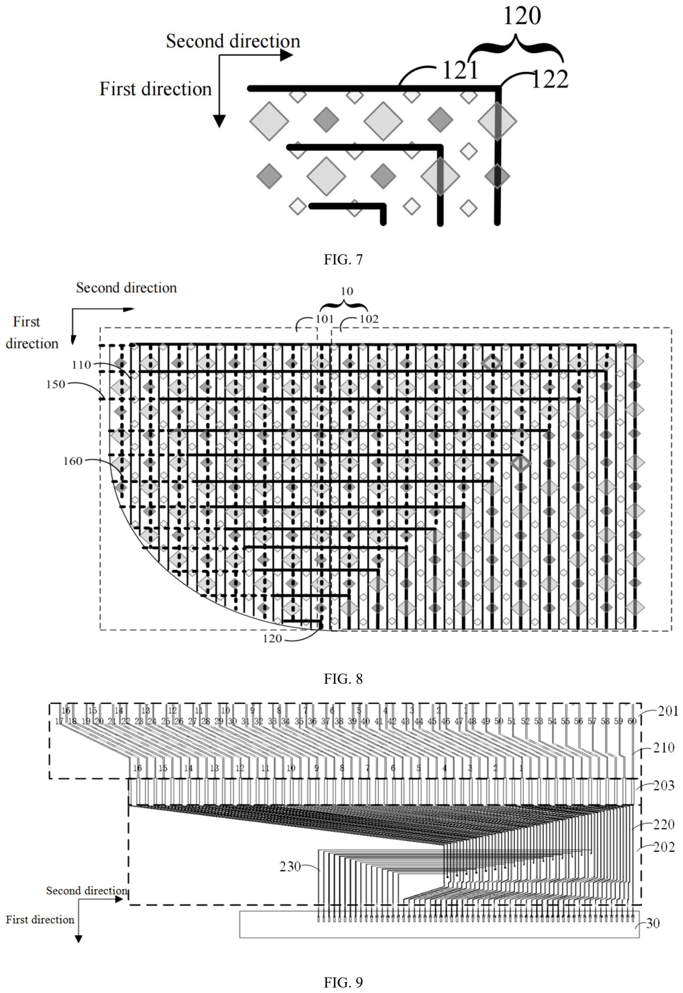

In some embodiments, as shown in FIG. 7, the first connection traces 120 may include a first trace portion 121 and a second trace portion 122.

The first trace portion 121 may be at least partially disposed in the first display region 101. An end of the first trace portion 121 may be connected to the corresponding data line 110 disposed in the first display region 101. An extension direction of the first trace portion 121 may be parallel to the second direction. The second trace portion 122 may be disposed in the second display region 102. An end of the second trace portion 122 may be connected to the first trace portion 121. Another end of the second trace portion 122 may be connected to the corresponding fan-out trace. The second trace portion 122 may extend along the first direction.

Through configuring the extension direction of the first trace portion 121 and the extension direction of the second trace portion 122 to correspond to the second direction and the first direction of the display module, respectively, the design and manufacturing complexity may be reduced to a large extent, and a production yield may be improved. It may be understood that in a case where the first trace portion 121 and the second trace portion 122 are disposed in different trace layers, the first trace portion 121 may be connected to the second trace portion 122 through the via. Furthermore, in combination with the above embodiments, among two adjacent first connection traces 120, an extension size of the first trace portion 121 that is farther from the virtual intersection point may be greater than an extension size of the first trace portion 121 closer to the virtual intersection point. In addition, an extension size of the second trace portion 122 that is farther from the virtual intersection point may be greater than an extension size of the second trace portion 122 closer to the virtual intersection point. In this way, occupation of the lower bezel edge region may be reduced, thereby further narrowing the size of the lower bezel. In addition, the overall wiring occupation area may be reduced, and coupling between the first connection traces 120 and the data lines 110 during signal transmission may be further decreased, thereby reducing parasitic capacitance generated between the first connection traces 120 and the data lines 110 and effectively minimizing delay and attenuation of data signals during transmission.

In some embodiments, as shown in FIG. 8, the display module may further include a plurality of second connection traces 150 and a plurality of third connection traces 160 (for the ease of illustration, the second connection traces 150 and the third connection traces 160 are indicated by dashed lines, while other features in the figure are indicated by solid lines).

The plurality of second connection traces 150 may be disposed in the display region. The plurality of second connection traces 150 may extend in the same direction as the first trace portion 121. The plurality of second connection traces 150 may be separated from the first trace portion 121 (a separation or partitioning region is not shown in the figure, but in practice, the second connection traces 150 and the first trace portion 121 are spaced apart from each other). The plurality of third connection traces 160 may be disposed in the display region. The plurality of third connection traces 160 may extend in the same direction as the second trace portions 122. The plurality of third connection traces 160 may be separated from the second trace portions 122 (a separation region is not shown in the figure, but in practice, the third connection traces 160 and the second trace portions 122 are spaced apart from each other).

An extension direction of the second connection traces 150 being the same as an extension direction of the first trace portion 121, may indicate that the second connection traces 150 extend along the second direction and are arranged along the first direction. An extension direction of the third connection traces 160 being the same as an extension direction of the second trace portions 122, may indicate that the third connection traces 160 extend along the first direction and are arranged along the second direction. It should be noted that the second connection traces 150 and the third connection traces 160 may not be configured to transmit signals. As such, no data lines 110 may be required to be connected to the second connection traces 150 and the third connection traces 160. In this sense, a position of the second connection traces 150 and a position of the third connection traces 160 may be understood as an unused location or idle location without occupying any additional spaced. The above design may further improve the uniformity of trace arrangement, thereby suppressing screen-off mura issues.

Comparing the embodiments between FIG. 3 and FIG. 8, in the embodiments of FIG. 3, the first connection traces 120 may be disposed in a part of each the first display region 101 and the second display region 102. The first connection traces 120 may be disposed in neither the remaining part of the first display region 101 nor the remaining part of the second display region 102. The first connection traces 120 may be metallic traces. It may be understood that the metallic trace has a certain reflective effect and the gap do not have any reflective effect. In this way, reflection effects at different locations of the display module may not necessarily be the same, thereby leading to screen-off mura issues in the display module. Clearly, in the embodiments of FIG. 8, the second connection traces 150 and the third connection traces 160 may be disposed in the gaps, so that reflection effects at the gap may become similar to reflection effects at regions in which the first connection traces 120 are located. In this way, the screen-off mura issues of the display module may be suppressed. In other words, regarding the screen-off mura, the performance of the display module in the embodiments of FIG. 8 may be superior to the performance of the display module in the embodiments of FIG. 3.

Furthermore, maintaining consistent structure across the display region of the display module may improve process stability, ensure uniform electrical characteristics of thin-film transistors, and maintain uniform display quality. Moreover, from a circuit design perspective, using the configuration of some embodiments of the present disclosure may reduce design complexity of the display module and allow integrated manufacturing of traces extending along the second direction. A separation region may be formed between the first trace portion 121 and the second connection trace 150, thereby forming or defining the first trace portion 121 and the second connection trace 150. Similarly, traces extending along the first direction may be integrally manufacturing. A separation region may be formed between the second trace portion 122 and the third connection trace 160, thereby forming or defining the second trace portion 122 and the third connection trace 160. During manufacturing, optical effects in exposure processes that cause dimensional variation may further be mitigated, thereby improving the production yield of the display module.

In some embodiments, as shown in FIG. 9 (the display region is not shown in the figure), the fan-out region may include a first fan-out region 201 and a second fan-out region 202. The second fan-out region 202 may be disposed between the first fan-out region 201 and the bonding region 30.

The plurality of fan-out traces may include: a plurality of first fan-out traces 210, a plurality of second fan-out traces 220, and a plurality of third fan-out traces 230.

The plurality of first fan-out traces 210 may be disposed in the first fan-out region 201 and respectively connected to the data lines 110 in the second display region 102 and to the another ends of the plurality of first connection traces 120. In this way, the plurality of first fan-out traces 210 may be configured to lead or transfer all the data lines 110 of the first display region 101 to the first fan-out region 201 through the plurality of first connection traces 120. The plurality of first fan-out traces 210 may further be configured to lead or transfer all the data lines 110 of the second display region 102 to the first fan-out region 201 directly.

The plurality of second fan-out traces 220 and the plurality of third fan-out traces 230 may be disposed in the second fan-out region 202. An end of each second fan-out trace 220 may be connected to a corresponding one of the first fan-out traces 210. For a part of the second fan-out traces 220, another end of each second fan-out trace 220 may be connected to a corresponding one of a part of the pins of the bonding region 30. For another part of the second fan-out traces 220, another end of each second fan-out trace 220 may be connected to a corresponding one of another part of the pins of the bonding region 30 through a corresponding one of the plurality of third fan-out traces 230. In this way, the plurality of second fan-out traces 220 may be configured to transfer all the data lines 110 of the display region to the second fan-out region 202 through the first fan-out traces 210. In addition, an arrangement sequence of the second fan-out traces 220 may be adjusted through the third fan-out traces 230, such that a final arrangement sequence of both the third fan-out traces 230 and the multiple second fan-out traces 220 that are connected to the plurality of pins of the bonding region 30 matches an original arrangement sequence of the data lines 110 along the second direction. Consequently, the plurality of pins in the bonding region 30 may maintain the same arrangement sequence as the data lines 110 without having to change the arrangement sequence of the pins.

Accordingly, through the plurality of first fan-out traces 210, the plurality of second fan-out traces 220, and the plurality of third fan-out traces 230, some embodiments of the present disclosure may transfer the data lines 110 in the second display region 102 and the first connection traces 120, whose arrangement sequence has been disturbed, to be connected to the plurality of pins in the bonding region 30 according to the original arrangement sequence of the data lines 110 along the second direction. As such, the plurality of pins in the bonding region 30 may still maintain the same arrangement sequence as the data lines 110, without having to alter the arrangement sequence of the pins. Thus, the manufacturing cost of the display screen may be reduced and a narrow bezel requirement may be achieved without affecting the functionality of the bonding region 30. Furthermore, since the third fan-out traces 230 are connected to the display region through the second fan-out traces 220, a size of the third fan-out trace 230 in the first direction may be smaller than a size of the second fan-out trace 220 in the first direction. In this way, an occupation area of the wiring transfer region in the second fan-out region 202 may be reduced to a large extent, thereby decreasing wiring complexity and improving an accommodation capacity of the second fan-out region 202 to contain other traces.

In some embodiments, the third fan-out traces 230 and the second fan-out traces 220 may be disposed in different trace layers of the display module. The trace layers may be disposed substantially perpendicular to a direction that is perpendicular to both the first direction and the second direction.

The third fan-out traces 230 and the second fan-out traces 220 may be disposed in different trace layers. On one hand, a chance of short circuits caused by the third fan-out traces 230 overlapping the second fan-out traces 220 may be reduced. Besides, coupling between the third fan-out traces 230 and the second fan-out traces 220 may be reduced. As such, the parasitic capacitance between the third fan-out traces 230 and the second fan-out traces 220 may be decreased, reducing delay and attenuation of data signals during transmission. Moreover, the above configuration may allow the second fan-out region 202 to provide more space to accommodate other traces and vias between the traces for trace switching. Furthermore, the plurality of third fan-out traces 230 may be electrically connected to the second fan-out traces through vias formed in the trace layer where the third fan-out traces 230 are located and/or through vias formed in the trace layer where the second fan-out traces 220 are located.

Further, as shown in FIG. 10 (the display region is not shown in the figure), any two adjacent second fan-out traces 220 may be alternately disposed on different trace layers of the display module. Any two adjacent third fan-out traces 230 may be alternately disposed on different trace layers of the display module. Through alternately disposing any two adjacent second fan-out traces 220 on different trace layers, and alternately disposing any two adjacent third fan-out traces 230 on different trace layers, the number of fan-out traces disposed on the same trace layer may be further reduced. As a result, arrangement positions of the fan-out traces on the same trace layer may be selected and adjusted with great flexibility to better match the target routing requirements.

Further, as shown in FIG. 11 (which may be referenced in conjunction with FIG. 6), the display module may further include a substrate and a gate insulation layer, an interlayer insulation layer, and a plurality of planarization layers sequentially stacked on the substrate. Any two adjacent second fan-out traces 220 may be alternately disposed in the gate insulation layer and the interlayer insulation layer. Any two adjacent third fan-out traces 230 may be alternately disposed in two adjacent planarization layers.

The gate insulation layer, the interlayer insulation layer, and the plurality of planarization layers may be referred to in the foregoing embodiments and will not be repeated herein.

The third fan-out traces 230 may be alternately disposed in trace layers of adjacent planarization layers (the trace layers of the adjacent planarization layers corresponding to the SD2 layer and SD3 layer shown in FIGS. 6 and 11). The second fan-out traces 220 may be alternately disposed in trace layers of the interlayer insulation layer (the trace layers of the adjacent planarization layers corresponding to a GE1 layer and a GE2 layer shown in FIGS. 6 and 11). In this way, the planarization layer and the interlayer insulation layer may be organic insulation layers with a typical thickness of 1.5 µm~2 µm. Such an arrangement may reduce parasitic capacitive load and minimize crosstalk between the second fan-out traces 220 and the third fan-out traces 230. The SD2 layer and the SD3 layer may be made of Ti/Al/Ti material, which is not limited thereto.

Further, in a case where the traces are alternately arranged, projections of any two adjacent second fan-out traces 220 onto the same trace layer of the display module may be configured to be substantially parallel to each other and arranged at equal intervals as required, such that a routing distribution of the projections of the second fan-out traces 220 in different trace layers onto the same trace layer may be uniform and regular; and/or, projections of any two adjacent third fan-out traces 230 onto the same trace layer of the display module may be configured to be substantially parallel to each other and arranged at equal intervals as required, such that a routing distribution of the projections of the third fan-out traces 230 in different trace layers onto the same trace layer may be uniform and regular.

Further, in a case where the traces are alternately arranged, the projections of any two adjacent second fan-out traces 220 onto the same trace layer of the display module may at least partially overlap with each other, such that the projections of the second fan-out traces 220 of different trace layers onto the same trace layer are concentrated in one region, and the above design may reduce the space occupied by the second fan-out traces 220 in the overall spatial layout, thereby facilitating a narrower fan-out region or providing more space for accommodating other traces; and/or, the projections of any two adjacent third fan-out traces 230 on the same trace layer of the display module may at least partially overlap with each other, such that the projections of the third fan-out traces 230 of different trace layers onto the same trace layer are concentrated in one region. The above design may reduce the space occupied by the third fan-out traces 230 in the overall spatial layout, thereby facilitating a narrower fan-out region or providing more space for accommodating other traces.

In some embodiments, as shown in FIG. 12 (the display region is not shown in the figure), the display module may further include a shielding layer 40.

The shielding layer 40 may be disposed between the trace layer where the second fan-out traces 220 are located and the trace layer where the third fan-out traces 230 are located. The shielding layer 40 may be connected to a predetermined voltage signal.

The predetermined voltage signal may be understood as a fixed voltage signal. Since the shielding layer 40 is disposed between the trace layer where the second fan-out traces 220 are disposed and the trace layer where the third fan-out traces 230 are disposed, and the shielding layer 40 is connected to the fixed voltage signal, the corresponding capacitance and voltage difference may remain constant. Thus, the corresponding signal interference may remain constant, which allows removal of signal interference and retention of valid signal data, thereby reducing a signal crosstalk between the second fan-out traces 220 and the third fan-out traces 230, and reducing delay and attenuation of data signals during transmission.

Further, the predetermined voltage signal may be a power supply (VDD) signal. Accordingly, the shielding layer 40 may be a power trace layer. On one hand, the power trace layer may perform a basic function of power signal transmission. On the other hand, the power trace layer, due to its positional configuration and transmission performance of the fixed voltage signal as mentioned above, may further perform a signal shielding function. In this way, a multiplexing function of the power trace layer may be realized, reducing the need to introduce an additional shielding layer for realizing corresponding signal isolation function. It may be understood that in some other embodiments, the predetermined voltage signal may be another type of signal, such as a ground (VSS) signal and so on. The shielding layer 40 may be a ground trace layer and etc., which will not be described in detail herein.

Further, as shown in FIG. 12, an orthographic projection of the shielding layer 40 onto the second fan-out region 202 may at least partially cover the second fan-out traces 220 and the third fan-out traces 230. In this way, the shielding layer 40 may at least partially isolate the crosstalk between the second fan-out traces 220 and the third fan-out traces 230. In some embodiments, the orthographic projection of the shielding layer 40 onto the second fan-out region 202 may completely cover the second fan-out traces 220 and the third fan-out traces 230, thereby completely isolating crosstalk between the second fan-out traces 220 and the third fan-out traces 230, so as to effectively reduce delay and attenuation of data signal during data transmission.

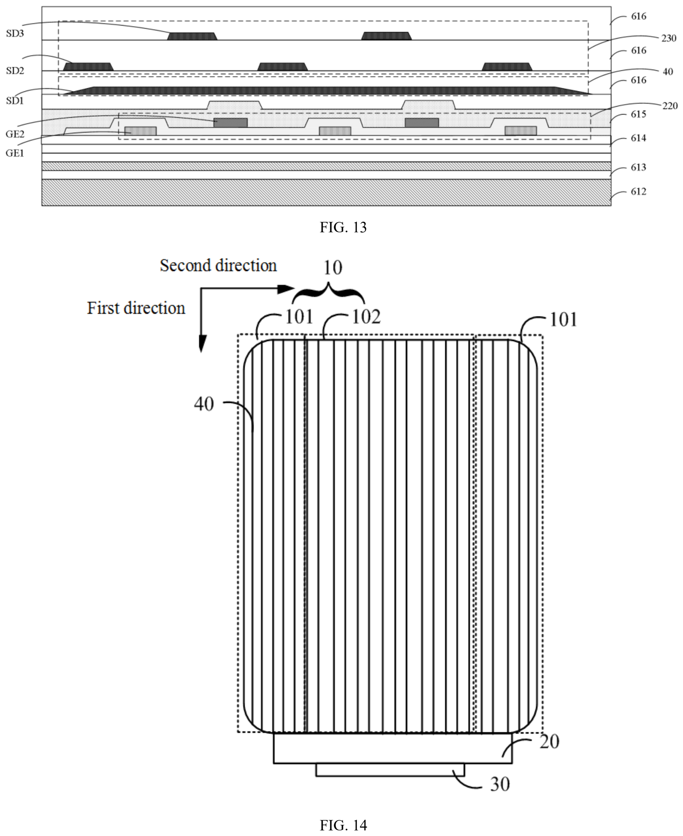

Further, according to the foregoing embodiments, the third fan-out traces 230 may be alternately disposed in trace layers of the adjacent planarization layers (the trace layers of the adjacent planarization layers corresponding to the SD2 layer and the SD3 layer shown in FIGS. 6, 11, and 13). In addition, the second fan-out traces 220 may be alternately disposed in trace layers of the interlayer insulation layer (the trace layers of the adjacent planarization layers corresponding to the GE1 layer and the GE2 layer shown in FIG. 6). In this case, the shielding layer 40 may be disposed in a planarization layer between the trace layer where the third fan-out traces 230 are located and the trace layer where the second fan-out traces 220 are located (corresponding to a SD1 layer shown in FIGS. 6 and 13).

In some embodiments, the display module may further include a bending region 203. The plurality of first fan-out traces 210 may be correspondingly connected to the second fan-out traces 220 through multiple traces in the bending region 203. Accordingly, the traces in the bending region 203 may be configured to transfer the multiple first fan-out traces 210 to the second fan-out traces 220. In addition, the arrangement of the bending region 203 may allow the second fan-out region 202 to be bent toward a back side of the display module, thereby improving the screen-to-body ratio.

It may be understood that for the traces in the foregoing embodiments, in some possible embodiments, the traces may each extend linearly or at least partially non-linearly. For example, the traces may each extend in a zigzag pattern, a serpentine pattern, a wavy pattern, or so on. Some embodiments of the present disclosure are not further limited thereto.

In some embodiments, the fan-out region may include the first fan-out region 201 and the second fan-out region 202. The second fan-out region 202 may be located between the first fan-out region 201 and the bonding region 30. The plurality of fan-out traces may include the plurality of first fan-out traces 210, a plurality of fourth fan-out traces, and a plurality of fifth fan-out traces.

The plurality of first fan-out traces 210 may be disposed in the first fan-out region 201. The plurality of first fan-out traces 210 may be respectively connected to the data lines 110 located in the second display region 102 and to the second ends of the first connection traces 120. The relevant description of the multiple first fan-out traces 210 may refer to the foregoing embodiments and will not be redundantly described herein.

The plurality of fourth fan-out traces may be disposed in the second fan-out region 202. An end of each fourth fan-out trace may be connected to a corresponding one of a part of the first fan-out traces 210. Another end of each fourth fan-out trace may be connected to a corresponding one of a part of the pins in the bonding region 30. The aforementioned part of the first fan-out traces 210 may be respectively connected to the first connection traces 120. The plurality of fifth fan-out traces may be disposed in the second fan-out region 202. An end of each fifth fan-out trace may be connected to a corresponding one of another part of the first fan-out traces 210. Another end of each fifth fan-out trace may be connected to a corresponding one of another part of the pins in the bonding region 30. The aforementioned another part of the first fan-out traces 210 may be respectively connected to the data lines 110 in the second display region 102.

Accordingly, by means of the multiple fourth fan-out traces and the multiple fifth fan-out traces, all data lines 110 in the display region may be transferred through the first fan-out traces 210 to the second fan-out region 202. An order of the multiple fourth fan-out traces and the multiple fifth fan-out traces may be rearranged, such that the multiple fourth fan-out traces and the multiple fifth fan-out traces ultimately connected to the multiple pins of the bonding region 30 are aligned in the same order as the original arrangement sequence of the data lines 110 along the second direction. Thus, the multiple pins of the bonding region 30 may maintain the same arrangement sequence as the data lines 110, without having to alter the arrangement sequence of the pins.

Accordingly, some embodiments of the present disclosure may utilize the multiple first fan-out traces 210, the multiple fourth fan-out traces, and the multiple fifth fan-out traces to transfer the data lines 110 of the second display region 102 and the first connection traces 120, whose arrangement sequence has been disturbed, to be connected to the multiple pins of the bonding region 30 in accordance with the original sequence arrangement of the data lines 110 along the second direction. As a result, the multiple pins of the bonding region 30 may still maintain the same arrangement sequence as the data lines 110, without having to alter the arrangement sequence of the pins. As such, the manufacturing cost of the display screen may be reduced and a narrow-bezel design may be achieved without affecting the functionality of the bonding region 30.

It may be understood that the multiple fourth fan-out traces and the multiple fifth fan-out traces may be disposed in different trace layers. Any two adjacent fourth fan-out traces may be alternately disposed in different trace layers. Any two adjacent fifth fan-out traces may be alternately disposed in different trace layers. The routing configuration of the multiple fourth fan-out traces and the multiple fifth fan-out traces may refer to the routing configuration of the multiple second fan-out traces 220 and the multiple third fan-out traces 230 described in the foregoing embodiments, which will not be redundantly described herein.

In some embodiments, a size of an edge of the fan-out region away from the display region may be smaller than a size of an edge of the fan-out region close to the display region. Accordingly, at least a part of the first fan-out traces 210 in the first fan-out region 201 may be inclined toward a central region, where a greater degree of inclination may result in a smaller size of the first fan-out traces 210 in the first direction, thereby facilitating a narrower first fan-out region 201. At least a part of the second fan-out traces 220 in the second fan-out region 202 may be inclined toward the central region, where a greater degree of inclination may result in a smaller size of the second fan-out traces 220 in the first direction, thereby facilitating a narrower second fan-out region 202.

In some embodiments, as shown in FIG. 14, the display module may include two first display regions 101. The two first display regions 101 may be respectively located on two opposite sides of the second display region 102 along the second direction. An overall outer contour of the second display region 102 and the two first display regions 101 may substantially be in shape of a rounded-corner rectangle. The first display regions 101 may correspond to a rounded-corner region of the rounded-corner rectangle. The second display region 102 may correspond to a rectangle region of the rounded-corner rectangle.

Through the multiple first connection traces 120, multiple first fan-out traces 210 that are correspondingly connected to the data lines 110 located in first display regions 101, serving as the rounded-corner region, may be transferred to the second display region 102, away from the rounded-corner region of the display region. As a result, the routing of the first fan-out regions 201 may be concentrated in the central region below the second display region 102, serving as the rectangle region, thereby reducing the routing space of the first fan-out regions 201 and further narrowing the lower bezel width of the display module.

It may be understood that, in a case where the arrangement manner of the first connection traces 120 in some embodiments of the present disclosure is not adopted, the fan-out traces in the rounded-corner region may have to be connected to the bending region 203 in an approximately arc-shaped routing manner. However, manufacturing such arc-shaped traces may be difficult, thereby affecting the manufacturing yield and even the display quality of the display module. As such, by adopting the arrangement manner of the first connection traces in some embodiments of the present disclosure, the traces in the rounded-corner region may be arranged in a linear manner, thereby reducing the process difficulty of the fan-out traces.

Based on the same inventive concept as the foregoing embodiments, the present disclosure may further provide another embodiment of the display module. The display module may include a display region, a fan-out region, and a bonding region sequentially disposed along a first direction. The display region may include a first display region and a second display region sequentially disposed along a second direction. The fan-out region may be adjacent to the second display region. The first direction and the second direction may intersect with each other. The display module may include: a plurality of data lines, a plurality of first connection traces, and a plurality of fan-out traces.

The plurality of data lines may be disposed in the display region. The plurality of data lines may extend along the first direction and may be disposed along the second direction. The plurality of first connection traces may be disposed in the display region. A first end of each first connection trace may be connected to a corresponding one of the data lines in the first display region. A second end of each first connection trace may be connected to a corresponding one of the fan-out traces and located in the second display region. For two adjacent first connection traces, the one whose first end is closer to the second display region may be referred to as a connection trace A, and the other one whose first end is farther from the second display region may be referred to as a connection trace B. The second end of the connection trace A may be closer to the first display region than the second end of the connection trace B. The plurality of fan-out traces may be disposed in the fan-out region. For a part of the fan-out traces, an end of each fan-out trace may be connected to the corresponding data line located in the second display region. For another part of the fan-out traces, an end of each fan-out trace may be connected to the second end of the corresponding first connection trace. An another end of each fan-out trace may be connected to a corresponding one of a plurality of pins disposed in the bonding region along the second direction. Each pin may be configured to transmit a data signal to the corresponding data line connected thereto. The arrangement sequence of each of the plurality of pins may be the same as the arrangement sequence of the corresponding one of the data lines connected thereto.

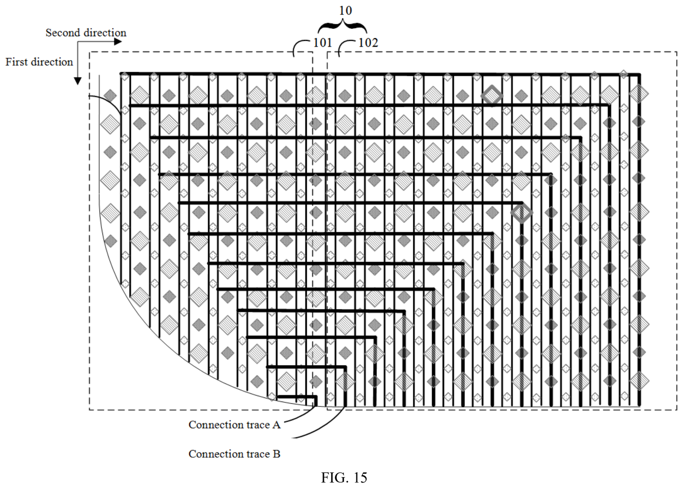

Among any two adjacent first connection traces, the one whose first end is closer to the second display region may be defined as the connection trace A (as shown in FIG. 15, where numeral 110 denotes the data line, numeral 101 denotes the first display region, and numeral 102 denotes the second display region), and the one whose first end is farther from the second display region may be defined as the connection trace B (as shown in FIG. 15). The second end of the connection trace A being closer to the first display region than the second end of the connection trace B, may be understood in a similar way as some embodiments mentioned previously. That is, according to those previous embodiments, among two adjacent data lines located in the first display region, a distance between the virtual intersection point and a first connection trace connected to the data line that is farther from the second display region may be greater than a distance between the virtual intersection point and another first connection trace connected to the other data line that is closer to the second display region.

Furthermore, among two adjacent first connection traces, an extension size of the connection trace A in the first direction may be smaller than an extension size of the connection trace B in the first direction. In addition, an extension size of the connection trace A in the second direction may be smaller than an extension size of the connection trace B in the second direction. The above features may be understood in a similar manner as the features in some embodiments mentioned previously. That is, according to those previous embodiments, for two adjacent first connection traces, an extension size of the first connection trace that is farther from the virtual intersection point in the first direction may be greater than an extension size of the other first connection trace that is closer to the virtual intersection point in the first direction. In addition, an extension size of the first connection trace that is farther from the virtual intersection point in the second direction may be greater than an extension size of the other first connection trace that is closer to the virtual intersection point in the second direction.

Accordingly, it may be understood that any description and further limiting embodiment related to any feature in some embodiments of the present disclosure may refer to one or more of the related embodiments of the display module described above, which will not be repeated herein.

The display module provided in some embodiments of the present disclosure may include the plurality of data lines and the plurality of first connection traces disposed in the display region, and the plurality of fan-out traces disposed in the fan-out region. The fan-out traces may be configured to transmit the data signals output from the bonding region to the data lines. Through the plurality of first connection traces, the plurality of fan-out traces correspondingly connected to the plurality of data lines in the first display region may be transferred to the second display region, that is, away from the edge region of the display module. As a result, the wiring in the fan-out region may be concentrated in the central region below the second display region, thereby reducing the wiring space of the fan-out region and further reducing the width of the lower bezel of the display module. Among any two adjacent first connection traces, the one whose first end is closer to the second display region is defined as the connection trace A, and the other one whose first end is farther from the second display region is defined as the connection trace B. The second end of the connection trace A may be closer to the first display region than the second end of the connection trace B, thereby further reducing the occupation of the edge region, narrowing the size of the lower bezel, and reducing the overall occupation area of the routing. In this way, the coupling between the first connection traces and the data lines during signal transmission may be reduced, thereby reducing parasitic capacitance generated between the first connection traces and the data lines and effectively reducing the delay and attenuation of the data signals during transmission. In addition, the fan-out traces in the fan-out region may be further configured to transfer the data lines of the second display region and the first connection traces, whose arrangement sequence has been disturbed, to be connected to the plurality of pins in the bonding region in accordance with the original arrangement sequence of the data lines along the second direction. As such, the plurality of pins in the bonding region still maintain the same arrangement sequence as the data lines. Thus, the arrangement sequence of the pins may not need to be altered or adjusted, which may reduce the manufacturing cost of the display screen and meet a narrow bezel requirement without affecting the functionality of the bonding region.

Based on the same inventive concept as the foregoing embodiments, the present disclosure may further provide another embodiment of the display module. The display module may include the display region, the fan-out region, and the bonding region sequentially disposed along the first direction. The display region may include the first display region and the second display region sequentially disposed along the second direction. The fan-out region may be adjacent to the second display region. The first direction and the second direction may intersect with each other. The display module may include: the plurality of data lines, the plurality of first connection traces, and the plurality of fan-out traces.

The plurality of data lines may be disposed in the display region. The plurality of data lines may extend along the first direction and may be disposed along the second direction. The plurality of first connection traces may be disposed in the display region. The first ends of the plurality of first connection traces may be respectively connected to the data lines located in the first display region. The second ends of the plurality of first connection traces may be located in the second display region. Among the adjacent data lines located in the first display region, the size of the first connection trace correspondingly connected to the data line farther from the second display region may be greater than the size of the first connection trace correspondingly connected to the data line closer to the second display region. The plurality of fan-out traces may be disposed in the fan-out region. For a part of the fan-out traces, an end of each fan-out trace may be connected to the corresponding data line located in the second display region. For another part of the fan-out traces, an end of each fan-out trace may be connected to the second end of the corresponding first connection trace. An another end of each fan-out trace may be connected to a corresponding one of a plurality of pins disposed in the bonding region along the second direction. Each pin may be configured to transmit the data signal to the corresponding data line connected thereto. The arrangement sequence of each of the plurality of pins may be the same as the arrangement sequence of a corresponding one of the plurality of data lines connected thereto.

Among two adjacent data lines in the first display region, the size of the first connection trace correspondingly connected to the data line that is farther from the second display region may be greater than the size of the other first connection trace correspondingly connected to the data line that is closer to the second display region. The above features may be understood in a similar way as some embodiments mentioned previously. That is, according to those previous embodiments, among two adjacent data lines located in the first display region, the distance between the virtual intersection point and the first connection trace correspondingly connected to the data line that is farther from the second display region may be greater than the distance between the virtual intersection point and another first connection trace correspondingly connected to the other data line that is closer to the second display region.

Furthermore, among the adjacent data lines in the first display region, the extension size of the corresponding first connection trace, connected to the data line that is farther from the second display region, in the first direction may be greater than the extension size of the corresponding first connection trace, connected to the other data line that is closer to the second display region, in the first direction. In addition, the extension size of the corresponding first connection trace, connected to the data line that is farther from the second display region, in the second direction may be greater than the extension size of the corresponding first connection trace, connected to the data line that is closer to the second display region, in the second direction. The above features may be understood in a similar manner as the features in some embodiments mentioned previously. That is, according to those previous embodiments, among two adjacent first connection traces, the extension size of the first connection trace that is farther from the virtual intersection point in the first direction may be greater than the extension size of the other first connection trace that is closer to the virtual intersection point in the first direction. In addition, the extension size of the first connection trace that is farther from the virtual intersection point in the second direction may be greater than the extension size of the other first connection trace that is closer to the virtual intersection point in the second direction.

Accordingly, it may be understood that any description and further limiting embodiment related to any feature in some embodiments of the present disclosure may refer to one or more of the related embodiments of the display module described above, which will not be repeated herein.

The display module provided in some embodiments of the present disclosure may include the plurality of data lines and the plurality of first connection traces disposed in the display region, and the plurality of fan-out traces disposed in the fan-out region. The fan-out traces may be configured to transmit the data signals output from the bonding region to the data lines. Through the plurality of first connection traces, the plurality of fan-out traces correspondingly connected to the plurality of data lines in the first display region may be transferred to the second display region, that is, away from the edge region of the display module. As a result, the routing in the fan-out region may be concentrated in the central region below the second display region, reducing the wiring space of the fan-out region and thus reducing the width of the lower bezel of the display module. Among the adjacent data lines in the first display region, the size of the first connection trace correspondingly connected to the data line that is farther from the second display region may be greater than the size of the first connection trace correspondingly connected to the other data line that is closer to the second display region, thereby further reducing the occupation of the edge region, narrowing the size of the lower bezel, and reducing the overall occupation area of the routing. In this way, the coupling between the first connection traces and the data lines during signal transmission may be reduced, thereby reducing parasitic capacitance generated between the first connection traces and the data lines and effectively reducing the delay and attenuation of the data signals during transmission. In addition, the fan-out traces in the fan-out region may be further configured to transfer the data lines of the second display region and the first connection traces, whose arrangement sequence has been disturbed, to be connected to the plurality of pins in the bonding region in accordance with the original arrangement sequence of the data lines along the second direction. As such, the plurality of pins in the bonding region still maintain the same arrangement sequence as the data lines. Thus, the arrangement sequence of the pins may not need to be altered or adjusted, which may reduce the manufacturing cost of the display screen and meet a narrow bezel requirement without affecting the functionality of the bonding region.

Some embodiments of the present disclosure may further provide a display screen. The display screen may include a cover plate and the display module as described above. The cover plate may be a glass cover plate disposed on a light-emitting surface of the display module. Furthermore, the cover plate may be a touch-screen glass cover plate, thereby realizing a protective function for the display module and providing a decorative function for an appearance of the touch screen. In some embodiments of the present disclosure, based on the above display module, the display screen having the narrow bezel may be provided.

Some embodiments of the present disclosure may further provide a display device. The display device may include the display module as described above. In some embodiments of the present disclosure, based on the above display module, the display device having the narrow bezel may be provided.

The technical features of the above embodiments may be arbitrarily combined. For the sake of brevity, all possible combinations of the various technical features in the above embodiments are not described. However, as long as there is no contradiction among such combinations, they shall be regarded as falling within the scope described in the present specification.

The above embodiments merely illustrate several embodiments of the present disclosure, and are described in a more specific and detailed manner, but they should not be construed as limitations to the scope of the present disclosure. It should be noted that, for those skilled in the art, several modifications and improvements may still be made without departing from the inventive concept of the present disclosure, and all such modifications and improvements shall fall within the protection scope of the present disclosure. Therefore, the protection scope of the present disclosure shall be defined by the appended claims.

## Claims

1. A display module, defining a display region, a fan-out region, and a bonding region sequentially along a first direction, the display region comprising a first display region and a second display region that are sequentially disposed along a second direction, the fan-out region being adjacent to the second display region, and the first direction and the second direction intersecting with each other, the display module comprising:
a plurality of data lines, disposed in the display region, wherein the plurality of data lines extend along the first direction and are arranged along the second direction;
a plurality of first connection traces, disposed in the display region, wherein
a first end of each of the plurality of first connection traces is connected to a corresponding one of the plurality of data lines located in the first display region, and a second end of each of the plurality of first connection traces is located in the second display region;
among adjacent two of the plurality of data lines located in the first display region, a distance between a virtual intersection point and one of the first connection traces correspondingly connected to one of the adjacent two of the plurality of data lines that is farther from the second display region is greater than a distance between the virtual intersection point and another one of the first connection traces correspondingly connected to the other one of the adjacent two of the plurality of data lines that is closer to the second display region; and
the virtual intersection point is an intersection point of a first extension line and a second extension line, the first extension line is an extension line of an edge of the first display region that is away from the second display region, and the second extension line is an extension line of an edge of the second display region that is adjacent to the fan-out region; and
a plurality of fan-out traces, disposed in the fan-out region, wherein
for a part of the plurality of fan-out traces, an end of each of the plurality of fan-out traces is connected to a corresponding one of the plurality of data lines located in the second display region;
for another part of the plurality of fan-out traces, an end of each of the plurality of fan-out traces is connected to the second end of a corresponding one of the plurality of first connection traces; and
another end of each of the plurality of fan-out traces is connected to a corresponding one of a plurality of pins disposed along the second direction in the bonding region, each of the plurality of pins is configured to transmit a data signal to a corresponding one of data lines connected thereto, and an arrangement sequence of each of the plurality of pins is the same as an arrangement sequence of the corresponding one of the plurality of data lines connected thereto.

2. The display module as claimed in claim 1, wherein the fan-out region comprises a first fan-out region and a second fan-out region, the second fan-out region is disposed between the first fan-out region and the bonding region; and
the plurality of fan-out traces comprises:
a plurality of first fan-out traces, disposed in the first fan-out region, wherein each of the plurality of first fan-out traces is connected to a corresponding one of the plurality of data lines located in the second display region or to another end of a corresponding one of the plurality of first connection traces; and
a plurality of second fan-out traces and a plurality of third fan-out traces, both disposed in the second fan-out region, wherein
an end of each of the plurality of second fan-out traces is connected to a corresponding one of the plurality of first fan-out traces;
for a part of the plurality of second fan-out traces, another end of each of the plurality of second fan-out traces is connected to a corresponding one of a part of the plurality of pins in the bonding region; and
for another part of the plurality of second fan-out traces, another end of each of the plurality of second fan-out traces is connected to a corresponding one of another part of the plurality of pins in the bonding region through a corresponding one of the plurality of third fan-out traces.

3. The display module as claimed in claim 2, wherein the plurality of third fan-out traces and the plurality of second fan-out traces are disposed in different trace layers of the display module, and the trace layers are substantially perpendicular to a direction that is perpendicular to both the first direction and the second direction.

4. The display module as claimed in claim 3, wherein the plurality of third fan-out traces are electrically connected to the plurality of second fan-out traces through vias defined in the trace layers where the third fan-out traces are located and/or through vias defined in the trace layers where the second fan-out traces are located.

5. The display module as claimed in claim 3, wherein any adjacent two of the plurality of second fan-out traces are alternately disposed in the different traces layers of the display module, and any adjacent two of the plurality of third fan-out traces are alternately disposed in the different trace layers of the display module.

6. The display module as claimed in claim 5, further comprising:
a substrate; and
a gate insulating layer, an interlayer insulating layer, and a plurality of planarization layers that are sequentially stacked on the substrate;
wherein any adjacent two of the plurality of second fan-out traces are alternately disposed in the gate insulating layer and the interlayer insulating layer, and any adjacent two of the plurality of third fan-out traces are alternately disposed in adjacent two of the plurality of planarization layers.

7. The display module as claimed in claim 5, wherein projections of any adjacent two of the plurality of second fan-out traces onto the same trace layer of the display module are substantially parallel to each other and arranged at equal intervals.

8. The display module as claimed in claim 5, wherein projections of any adjacent two of the plurality of third fan-out traces onto the same trace layer of the display module are substantially parallel to each other and arranged at equal intervals.

9. The display module as claimed in claim 5, wherein projections of any adjacent two of the plurality of second fan-out traces onto the same trace layer of the display module at least partially overlap with each other.

10. The display module as claimed in claim 5, wherein projections of any adjacent two of the plurality of third fan-out traces onto the same trace layer of the display module at least partially overlap with each other.

11. The display module as claimed in claim 3, further comprising:
a shielding layer, disposed between the trace layers where the plurality of second fan-out traces are located and the trace layers where the plurality of third fan-out traces are located, and connected to a predetermined voltage signal.

12. The display module as claimed in claim 11, wherein a projection of the shielding layer onto the second fan-out region at least partially covers the plurality of second fan-out traces and the plurality of third fan-out traces.

13. The display module as claimed in claim 11, wherein the plurality of third fan-out traces are alternately disposed in the trace layers located in adjacent ones of the plurality of planarization layers, the plurality of second fan-out traces are alternately disposed in the trace layers located in the interlayer insulating layer, and the shielding layer is disposed in a part of the plurality of planarization layers located between the trace layers where the third fan-out traces are located and the trace layers where the second fan-out traces are located.

14. The display module as claimed in claim **11,** wherein the predetermined voltage signal comprises a power supply signal, and the shielding layer comprises a power trace layer.

15. The display module as claimed in claim 11, wherein the predetermined voltage signal comprises a ground signal, and the shielding layer comprises a ground trace layer.

16. The display module as claimed in claim 2, wherein the fan-out region comprises a bending region, and the plurality of first fan-out traces are correspondingly connected to the plurality of second fan-out traces through a plurality of electrical connection lines in the bending region.

17. The display module as claimed in claim 1, wherein the fan-out region comprises a first fan-out region and a second fan-out region, the first fan-out region is located at a side of the second fan-out region away from the bonding region along the first direction; and
the plurality of fan-out traces comprises:
a plurality of first fan-out traces, disposed in the first fan-out region, wherein each of the plurality of first fan-out traces is connected to a corresponding one of the plurality of data lines located in the second display region or to another end of a corresponding one of the plurality of first connection traces;
a plurality of fourth fan-out traces, disposed in the second fan-out region, wherein an end of each of the plurality of fourth fan-out traces is connected to a corresponding one of a part of the plurality of first fan-out traces, another end of each of the plurality of fourth fan-out traces is connected to a corresponding one of a part of the plurality of pins in the bonding region, and the part of the plurality of first fan-out traces are respectively connected to the plurality of first connection traces; and
a plurality of fifth fan-out traces, disposed in the second fan-out region, wherein an end of each of the plurality of fifth fan-out traces is connected to a corresponding one of another part of the plurality of first fan-out traces, another end of each of the plurality of fifth fan-out traces is connected to a corresponding one of another part of the plurality of pins in the bonding region, and the another part of the plurality of first fan-out traces are respectively connected to the plurality of data lines located in the second display region.

18. The display module as claimed in claim 1, wherein among adjacent two of the plurality of first connection traces:
an extension size of one of the adjacent two of the plurality of first connection traces that is farther from the virtual intersection point in the first direction is greater than an extension size of the other one of the adjacent two of the plurality of first connection traces that is closer to the virtual intersection point in the first direction; and
an extension size of one of the adjacent two of the plurality of first connection traces that is farther from the virtual intersection point in the second direction is greater than an extension size of the other one of the adjacent two of the plurality of first connection traces that is closer to the virtual intersection point in the second direction.

19. The display module as claimed in claim 18, wherein a projection of a trace portion of each of the plurality of first connection traces extending along the first direction along a thickness direction of the display module is located in a gap between adjacent two of the plurality of data lines.

20. The display module as claimed in claim 19, wherein the trace portion is located in the same trace layer of the display module as the plurality of data lines, and another trace portion of each of the plurality of first connection traces, apart from the trace portion, and the plurality of data lines are located in the different trace layers of the display module; and
wherein the another trace portion is respectively connected to the trace portion and a corresponding part of plurality of data lines through vias.

21. The display module as claimed in claim 20, wherein in a case where the trace portion of the plurality of first connection traces that extends along the first direction is disposed in the same trace layer as the plurality of data lines, a width of the gap between adjacent two of the plurality of data lines is greater than a width threshold.

22. The display module as claimed in claim 19, further comprising:
a plurality of pixel circuits, disposed in a plurality of columns, wherein the first direction is substantially parallel to a column direction of the plurality of pixel circuits, each of the plurality of columns comprises more than one of the plurality of the pixel circuits, and each of the plurality of pixel circuits is configured to be connected to one light-emitting device to drive the connected light-emitting device to emit light;
wherein each of the plurality of data lines is configured to transmit a data signal to a corresponding part of the plurality of pixel circuits in the column direction.

23. The display module as claimed in claim 18, wherein a projection of a trace portion of each of the plurality of first connection traces extending along the first direction in a thickness direction of the display module at least partially overlaps with an adjacent one of the plurality of data lines.

24. The display module as claimed in claim 18, wherein each of the plurality of first connection traces comprises:
a first trace portion, at least partially disposed in the first display region, wherein an end of the first trace portion is connected to a corresponding one of the plurality of data lines located in the first display region, and an extension direction of the first trace portion is substantially parallel to the second direction; and
a second trace portion, disposed in the second display region, wherein an end of the second trace portion is connected to the first trace portion, another end of the second trace portion is connected to a corresponding one of the plurality of fan-out traces, and the second trace portion extends along the first direction.

25. The display module as claimed in claim 24, further comprising:
a plurality of second connection traces, disposed in the display region, wherein an extension direction of the plurality of second connection traces is the same as the extension direction of the first trace portion, and the plurality of second connection traces are spaced apart from the first trace portion; and
a plurality of third connection traces, disposed in the display region, an extension direction of the plurality of third connection traces is the same as the extension direction of the second trace portion, and the plurality of third connection traces are spaced apart from the second trace portion.

26. The display module as claimed in any one of claims 1-25, wherein a size of an edge of the fan-out region away from the display region is smaller than a size of an edge of the fan-out region close to the display region.

27. The display module as claimed in any one of claims 1-25, wherein the number of the first display region defined in the display module is two, the two first sub-display regions are respectively disposed on two opposite sides of the second display region in the second direction; and
wherein an overall outer contour of the second display region and the two first sub-display regions is in shape of a rounded-corner rectangle, the first sub-display regions correspond to a rounded-corner region of the rounded-corner rectangle, and the second display region corresponds to a rectangle region of the rounded-corner rectangle.

28. A display module, defining a display region, a fan-out region, and a bonding region sequentially along a first direction, the display region comprising a first display region and a second display region that are sequentially disposed along a second direction, the fan-out region being adjacent to the second display region, and the first direction and the second direction intersecting with each other, the display module comprising:
a plurality of data lines, disposed in the display region, wherein the plurality of data lines extend along the first direction and are arranged along the second direction;
a plurality of first connection traces, disposed in the display region, wherein
a first end of each of the plurality of first connection traces is connected to a corresponding one of the plurality of data lines located in the first display region, and a second end of each of the plurality of first connection traces is connected to a corresponding one of the plurality of fan-out traces and is located in the second display region;
among adjacent two of the plurality of first connection traces, one of the adjacent two of the plurality of first connection traces of which the first end is closer to the second display region is defined as a first sub connection trace, the other one of the adjacent two of the plurality of first connection traces of which the first end is farther from the second display region is defined as a second sub connection trace, and the second end of the first sub connection trace is closer to the first display region than the second end of the second sub connection trace; and
a plurality of fan-out traces, disposed in the fan-out region, wherein
for a part of the plurality of fan-out traces, an end of each of the plurality of fan-out traces is connected to a corresponding one of the plurality of data lines located in the second display region;
for another part of the plurality of fan-out traces, an end of each of the plurality of fan-out traces is connected to the second end of a corresponding one of the plurality of first connection traces; and
another end of each of the plurality of fan-out traces is connected to a corresponding one of a plurality of pins disposed along the second direction in the bonding region, each of the plurality of pins is configured to transmit a data signal to a corresponding one of data lines connected thereto, and an arrangement sequence of each of the plurality of pins is the same as an arrangement sequence of the corresponding one of the plurality of data lines connected thereto.

29. The display module as claimed in claim 28, wherein the fan-out region comprises a first fan-out region and a second fan-out region, the second fan-out region is disposed between the first fan-out region and the bonding region; and
the plurality of fan-out traces comprises:
a plurality of first fan-out traces, disposed in the first fan-out region, wherein each of the plurality of first fan-out traces is connected to a corresponding one of the plurality of data lines located in the second display region or to the second end of a corresponding one of the plurality of first connection traces;
a plurality of second fan-out traces and a plurality of third fan-out traces, both disposed in the second fan-out region, wherein
an end of each of the plurality of second fan-out traces is connected to a corresponding one of the plurality of first fan-out traces;
for a part of the plurality of second fan-out traces, another end of each of the plurality of second fan-out traces is connected to a corresponding one of a part of the plurality of pins in the bonding region; and
for another part of the plurality of second fan-out traces, another end of each of the plurality of second fan-out traces is connected to a corresponding one of another part of the plurality of pins in the bonding region through a corresponding one of the plurality of third fan-out traces.

30. The display module as claimed in claim 29, wherein the plurality of third fan-out traces and the plurality of second fan-out traces are disposed in different trace layers of the display module, and the trace layers are substantially perpendicular to a direction that is perpendicular to both the first direction and the second direction.

31. The display module as claimed in claim 28, wherein the fan-out region comprises a first fan-out region and a second fan-out region, the first fan-out region is located at a side of the second fan-out region away from the bonding region along the first direction; and
the plurality of fan-out traces comprises:
a plurality of first fan-out traces, disposed in the first fan-out region, wherein each of the plurality of first fan-out traces is connected to a corresponding one of the plurality of data lines located in the second display region or to the second end of a corresponding one of the plurality of first connection traces;
a plurality of fourth fan-out traces, disposed in the second fan-out region, wherein an end of each of the plurality of fourth fan-out traces is connected to a corresponding one of a part of the plurality of first fan-out traces, another end of each of the plurality of fourth fan-out traces is connected to a corresponding one of a part of the plurality of pins in the bonding region, and the part of the plurality of first fan-out traces are respectively connected to the plurality of first connection traces; and
a plurality of fifth fan-out traces, disposed in the second fan-out region, wherein an end of each of the plurality of fifth fan-out traces is connected to a corresponding one of another part of the plurality of first fan-out traces, another end of each of the plurality of fifth fan-out traces is connected to a corresponding one of another part of the plurality of pins in the bonding region, and the another part of the plurality of first fan-out traces are respectively connected to the plurality of data lines located in the second display region.

32. The display module as claimed in claim 28, wherein among the adjacent two of the plurality of first connection traces, an extension size of the first sub connection trace along the first direction is smaller than an extension size of the second sub connection trace along the first direction, and an extension size of the first sub connection trace along the second direction is smaller than an extension size of the second sub connection trace along the second direction.

33. A display module, defining a display region, a fan-out region, and a bonding region sequentially along a first direction, the display region comprising a first display region and a second display region that are sequentially disposed along a second direction, the fan-out region being adjacent to the second display region, and the first direction and the second direction intersecting with each other, the display module comprising:
a plurality of data lines, disposed in the display region, wherein the plurality of data lines extend along the first direction and are arranged along the second direction;
a plurality of first connection traces, disposed in the display region, wherein
a first end of each of the plurality of first connection traces is connected to a corresponding one of the plurality of data lines located in the first display region, and a second end of each of the plurality of first connection traces is located in the second display region;
among adjacent two of the plurality of data lines located in the first display region, a length size of one of the plurality of first connection traces that is connected to one of the adjacent two of the plurality of data lines farther from the second display region is greater than a length size of another one of the plurality of first connection traces that is connected to the other one of the adjacent two of the plurality of data lines closer to the second display region; and
a plurality of fan-out traces, disposed in the fan-out region, wherein
for a part of the plurality of fan-out traces, an end of each of the plurality of fan-out traces is connected to a corresponding one of the plurality of data lines located in the second display region;
for another part of the plurality of fan-out traces, an end of each of the plurality of fan-out traces is connected to another end of a corresponding one of the plurality of first connection traces; and
another end of each of the plurality of fan-out traces is connected to a corresponding one of a plurality of pins disposed along the second direction in the bonding region, each of the plurality of pins is configured to transmit a data signal to a corresponding one of data lines connected thereto, and an arrangement sequence of each of the plurality of pins is the same as an arrangement sequence of the corresponding one of the plurality of data lines connected thereto.

34. The display module as claimed in claim 33, wherein the fan-out region comprises a first fan-out region and a second fan-out region, the second fan-out region is disposed between the first fan-out region and the bonding region; and
the plurality of fan-out traces comprises:
a plurality of first fan-out traces, disposed in the first fan-out region, wherein each of the plurality of first fan-out traces is connected to a corresponding one of the plurality of data lines located in the second display region or to another end of a corresponding one of the plurality of first connection traces;
a plurality of second fan-out traces and a plurality of third fan-out traces, both disposed in the second fan-out region, wherein
an end of each of the plurality of second fan-out traces is connected to a corresponding one of the plurality of first fan-out traces; and
for a part of the plurality of second fan-out traces, another end of each of the plurality of second fan-out traces is connected to a corresponding one of a part of the plurality of pins in the bonding region; and for another part of the plurality of second fan-out traces, another end of each of the plurality of second fan-out traces is connected to a corresponding one of another part of the plurality of pins in the bonding region through a corresponding one of the plurality of third fan-out traces.

35. The display module as claimed in claim 34, wherein the plurality of third fan-out traces and the plurality of second fan-out traces are disposed in different trace layers of the display module, and the trace layers are substantially perpendicular to a direction that is perpendicular to both the first direction and the second direction.

36. The display module as claimed in claim 33, wherein the fan-out region comprises a first fan-out region and a second fan-out region, the first fan-out region is located at a side of the second fan-out region away from the bonding region along the first direction; and
the plurality of fan-out traces comprises:
a plurality of first fan-out traces, disposed in the first fan-out region, wherein each of the plurality of first fan-out traces is connected to a corresponding one of the plurality of data lines located in the second display region or to the second end of a corresponding one of the plurality of first connection traces;
a plurality of fourth fan-out traces, disposed in the second fan-out region, wherein an end of each of the plurality of fourth fan-out traces is connected to a corresponding one of a part of the plurality of first fan-out traces, another end of each of the plurality of fourth fan-out traces is connected to a corresponding one of a part of the plurality of pins in the bonding region, and the part of the plurality of first fan-out traces are respectively connected to the plurality of first connection traces; and
a plurality of fifth fan-out traces, disposed in the second fan-out region, wherein an end of each of the plurality of fifth fan-out traces is connected to a corresponding one of another part of the plurality of first fan-out traces, another end of each of the plurality of fifth fan-out traces is connected to a corresponding one of another part of the plurality of pins in the bonding region, and the another part of the plurality of first fan-out traces are respectively connected to the plurality of data lines located in the second display region.

37. The display module as claimed in claim 33, wherein among adjacent two of the plurality of data lines in the first display region:
an extension size of one of the plurality of first connection traces that is connected to one of the adjacent two of the plurality of data lines farther from the second display region along the first direction is greater than an extension size of another one of the plurality of first connection traces that is connected to the other one of the adjacent two of the plurality of data lines closer to the second display region along the first direction; and
an extension size of one of the plurality of first connection traces that is connected to one of the adjacent two of the plurality of data lines farther from the second display region along the second direction is greater than an extension size of another one of the plurality of first connection traces that is connected to the other one of the adjacent two of the plurality of data lines closer to the second display region along the second direction.

38. A display screen, comprising a cover plate and the display module as claimed in any one of claims 1-37.

39. A display device, comprising the display screen as claimed in claim 38.
